# EUROPÄISCHE PATENTSCHRIFT

(11) **EP 0 751 236 B1**
(45) Veröffentlichungstag und Bekanntmachung des Hinweises auf die Patenterteilung: **24.07.2002**
(21) Anmeldenummer: 96113800.5
(22) Anmeldetag: 13.02.1993
(51) Int. Cl.: C23C 14/54, C23C 14/00

(54) **Verfahren und Vorrichtung zur Herstellung dünner Schichten mittels reaktiver Kathodenzerstäubung zur Durchführung des Verfahrens**
Process for producing thin films by means of reactive sputtering and device for implementing it
Procédé et dispositif pour l'obtention de couches minces par pulvérisation cathodique réactive

(30) Priorität: 14.02.1992 DE 4204371; 22.08.1992 DE 4227961
(43) Veröffentlichungstag der Anmeldung: 02.01.1997
(62) Teilanmeldung aus: 93903170.4
(73) Patentinhaber: Forschungszentrum Jülich GmbH, 52425 Jülich (DE)
(72) Erfinder: Wördenweber, Roger, Dr., 52382 Niederzier (DE); Krüger, Ursus, Dr., 13595 Berlin (DE); Kutzner, Rolf, 52428 Jülich (DE)

(56) Entgegenhaltungen:
- EP-A- 0 282 835
- DE-A- 3 730 834
- FR-A- 2 503 190

## Beschreibung

Die Erfindung betrifft ein Verfahren zur Herstellung dünner Schichten mittels reaktiver Kathodenzerstäubung gemäß dem Oberbegriff des Anspruchs 1. Die Erfindung betrifft ferner eine Vorrichtung zur Herstellung dünner Schichten gemäß dem Oberbegriff des Anspruchs 10.

Nach der Entdeckung der oxydischen Hochtemperatursupraleiter im Jahre 1986 ist man bestrebt, diesen Werkstoff in der Mikroelektronik einzusetzen. Es handelt sich bei den oxydischen Hochtemperatursupraleitern um Materialien mit einer komplizierten Struktur. Damit möglichst gute, nach Möglichkeit epitaktisch aufgewachsene Schichten hergestellt werden können, ist es erforderlich, bei der Dünnschichtherstellung dieser oxydischen Hochtemperatursupraleiter einen optimierten und während der Deposition zeitlich möglichst stabilen Ablauf der Abscheidung zu gewährleisten.

Eine Möglichkeit der Dünnschichtherstellung solcher Materialien liegt in dem Verfahren der Kathodenzerstäubung. Dabei kann man mit entsprechend technischem Aufwand zwar die meisten Depositionsparameter, wie z.B. Substrat- oder Targettemperatur, Sputterleistung, Sputterstrom oder Prozeßgasdruck konstant halten.

Bei den bisher bekannten Kathodenzerstäubungsverfahren zeigt sich jedoch nachteilig, daß die abgeschiedenen Filme aus oxydischen Hochtemperatursupraleitern nicht perfekt einkristallin aufwachsen, sondern Inhomogenitäten in der Filmstruktur aufweisen.

Aus DE 37 30 834 A1 ist ein Verfahren und eine Vorrichtung zur physikalischen Dampfablagerung dünner Filme bekannt. Dabei wird ein Drucksteuersystem mit einem Ionenstrahl-Monitor in Form eines Faraday-Käfigs eingesetzt.

In EP 0 282 835 B1 und FR 2 503 190 A werden ebenfalls Verfahren und Vorrichtungen zur reaktiven Kathodenzerstäubung beschrieben, die einen Regelkreis zur Optimierung der Verfahrensbedingungen und zur Verbesserung der abzuscheidenden Schicht aufweisen. In beiden Dokumenten wird zur Regelung der Intensität eine Emissionslinie des Plasmas ausgewertet und entsprechend der Vergleichswerte werden die Gaszusammensetzungen bzw. auch der Sputterstrom geregelt.

Es ist daher Aufgabe der vorliegenden Erfindung, ein Verfahren der eingangs genannten Art zu schaffen, das die genannten Nachteile vermindert und im Ergebnis zu einem Dünnfilm, insbesondere aus einem oxydischen Hochtemperatursupraleiter, mit verminderter Inhomogenität führt. Es ist weiterhin Aufgabe der Erfindung, eine Vorrichtung zur Herstellung solcher Dünnschichten zu schaffen.

Die erfindungsgemäße Aufgabe wird durch ein Verfahren mit den Merkmalen des Anspruchs 1 gelöst.

Es wurde insbesondere bei der Abscheidung von hochtemperatursupraleitenden Materialien auf geeignete Substrate und dabei speziell im Falle einer großflächigen Deposition erkannt, daß die Sauerstoffkonzentration im Target aus YBa₂Cu₃Oₓ mit 6 < X < 7 an der Targetoberfläche stark variieren kann. Dies erscheint die Begründung für das Auftreten von inhomogenem und instabilem Abbrennen des Plasmas zu sein. Dabei spielen vor allem Änderungen des Gasstromes und das lokale Aufwärmen des Targets eine wesentliche Rolle. Es wurde erkannt, daß die Schwankungen des Sauerstoffgehaltes gezielt durch Zugabe bzw. Reduzierung des Sauerstoffanteils im Prozeßgasgemisch verhindert werden können, so daß das Plasma homogen abbrennt. Um dies zu erreichen wurde erkannt, daß der Sauerstoff detektiert werden muß. Dazu wird wenigstens eine Sonde, in vorteilhafter Weise eine Langmuirsonde oder ein Faradaykäfig zur Erfassung der im Plasma vorhandenen Ladungen so angebracht, daß sie zum einen das Plasma nicht stören (außerhalb der sichtbaren Plasmawolke), zum anderen sich aber in einem Bereich in dem der Sauerstoffanteil dominiert, beispielsweise neben dem Substrat, befinden. In diesem Falle ist die von der Sonde aufgefangene Spannung ein Maß für den beim Kathodenzerstäuben anwesenden Sauerstoffanteil. Es wurde erkannt, daß Änderungen in der Spannung direkt auf Änderungen des Sauerstoffgehaltes hinweisen und durch Zugabe oder Reduzierung des zugeführten Sauerstoffanteils im Prozeßgasmischungsverhältnis gegengeregelt werden können. Auf diese Weise wird im Ergebnis eine sehr einfache und extrem stabile Einstellung als Arbeitspunkt für die Deposition erreicht.

Das erfindungsgemäße Verfahren wird in den Ansprüchen 2 bis 9 in zweckmäßiger oder vorteilhafter Weise weiter ausgebildet.

Es wurde erkannt, daß die zeitliche Änderung im Plasma durch die Beteiligung von Sauerstoff bei der Deposition von Hochtemperatursupraleitern hervorgerufen werden kann. Der Sauerstoff wird in die aus oxydischem, hochtemperatursupraleitendem Material bestehenden Schicht eingebaut (z.B. YBa₂Cu₃O₇) und ist deswegen auch im Prozeßgas vorhanden. Der Sauerstoff kann dabei auf die Oberflächen, insbesondere auch die Targetoberfläche, angelagert oder wieder von ihnen freigegeben werden. Infolgedessen wird dem Abscheidungsprozeß Sauerstoff entzogen bzw. zugeführt. Es wurde erkannt, daß vor allem der Sauerstoffgehalt der Targetoberfläche bei diesen zeitlichen Änderungen im Plasma eine wesentliche Rolle spielen. Je nach Sauerstoffgehalt zeigen einige Hochtemperatursupraleiter (HTSL) metallisches bis Isolatorverhalten.

Das erfindungsgemäße Verfahren ist nicht auf die Herstellung dünner Schichten aus hochtemperatursupraleitenden Materialien beschränkt. Vielmehr ist das erfindungsgemäße Verfahren überall dort einsetzbar, wo mit Hilfe der reaktiven Kathodenzerstäubung dünne Schichten hergestellt werden.

Im Ergebnis liefert das erfindungsgemäße Verfahren eine kontrolliertere Deposition des HTSL-Materials auf das Substrat und damit eine Verbesserung der Qualität solcher mit Hilfe der Kathodenzerstäubung hergestellten Dünnfilme.

Das erfindungsgemäße Verfahren erfaßt vorteilhafterweise sowohl eine Optimierung als auch eine verbesserte Steuerung des Depositionsprozesses. Zur Optimierung des Prozeßgasmischungsverhältnisses wird das Prozeßgas gezielt an das Plasma herangeführt, bevorzugt in der Nähe der Targetoberfläche. Eine weitere Möglichkeit der Optimierung des Depositionsprozesses kann darin liegen, die Position des Substrates und/oder das Nachfahren der Substratposition zu beeinflussen in Abhängigkeit des Spannungswertes der Sonde(n). Dabei ist das erfindungsgemäße Verfahren keineswegs nur auf die Beschichtung kleiner Substrate, sondern in vorteilhafter Weise gerade auch bei großflächiger Beschichtung einsetzbar. Weiterhin können geeignete Profilblenden gezielt in das Targetplasma eingebracht werden.

Zur Verbesserung der HTSL-Schichtherstellung mit Hilfe der Kathodenzerstäubung erlaubt das erfindungsgemäße Verfahren eine Prozeßstabilisierung durch Konstanthaltung des Spannungswertes an der (den) Sonde(n). Dies kann durch zusätzliches und/oder vermindertes Anbieten des Prozeßgases geschehen.

An dieser Stelle sei erwähnt, daß zeitliche Veränderungen des Plasmas zum einen daher rühren, daß jedes sich in der Nähe des Plasmas befindliche Potential zu Veränderungen im elektrischen Feld und damit zu Veränderungen im Plasma führt. Die zeitlichen Schwankungen der Plasmaeigenschaften können durch Potentialänderungen beispielsweise durch Aufladung durch Ladungsübertrag von Ionen aus dem Plasma auf die Oberflächen hervorgerufen werden.

Die zeitliche Änderung im Plasma kann andererseits durch die Beteiligung von Sauerstoff bei der Deposition von Hochtemperatursupraleitern hervorgerufen werden. Der Sauerstoff wird in die aus oxydischem hochtemperatursupraleitendem Material bestehenden Schicht eingebaut (z.B. YBa₂Cu₃O₇) und ist deswegen auch im Prozeßgas vorhanden. Der Sauerstoff kann dabei auf die Oberflächen, insbesondere auch die Targetoberfläche, angelagert oder wieder von Ihnen freigegeben werden. Infolgedessen wird dem Abscheidungsprozeß Sauerstoff entzogen bzw. zugeführt. Es wurde erkannt, daß vor allem der Sauerstoffgehalt der Targetoberfläche bei diesen zeitlichen Änderungen im Plasma eine wesentliche Rolle spielen. Je nach Sauerstoffgehalt zeigen einige Hochtemperatursupraleiter (HTSL) metallisches oder Isolatorverhalten.

Das erfindungsgemäße Verfahren ist nicht auf die Herstellung dünner Schichten aus hochtemperatursupraleitenden Materialien beschränkt. Vielmehr ist das erfindungsgemäße Verfahren überall dort einsetzbar, wo mit Hilfe der reaktiven Kathodenzerstäubung dünne Schichten hergestellt werden.

Es wurde erkannt, daß die zeitlichen Änderungen des Plasmas sich aus zwei unterschiedlichen Komponenten zusammensetzen. Zum einen zeigt ein solches Targetplasma periodische Schwankungen im Bereich von einigen Minuten. Dazu wurde eine ausgewählte Emissionslinie einer Komponente des Plasmas emissionsspektroskopisch erfaßt und profilmäßig dargestellt. Zum anderen weist das Targetplasma Kurzzeitschwankungen im Bereich von Bruchteilen von Sekunden bis zu einigen Sekunden auf. Diese Schwankungen zeigen sich z.B. in der gemessenen integralen Intensität des emissionsspektroskopisch erfaßten Querschnittsprofils des Plasmas.

Gemäß dem erfindungsgemäßen Verfahren wird während der Kathodenzerstäubung das Querschnittsprofil emissionsspektroskopisch erfaßt, ein gewünschtes Querschnittsprofil eingestellt. Im zeitlichen Verlauf wird dieses Querschnittsprofil konstant gehalten, indem das Prozeßgasmischungsverhältnis nachgeregelt wird. In vorteilhafter Weise wird mit Hilfe des erfindungsgemäßen Verfahrens erreicht, daß infolge der Konstanz des Querschnittprofils auch die kurzzeitigen Schwankungen in der integralen Intensität des Emissionssignals stark reduziert werden. Im Ergebnis liefert das erfindungsgemäße Verfahren damit auch eine kontrolliertere Deposition des HTSL-Materials auf das Substrat und damit eine Verbesserung der Qualität solcher mit Hilfe der Kathodenzerstäubung hergestellten Dünnfilme.

Das erfindungsgemäße Verfahren erfaßt vorteilhafterweise sowohl eine Optimierung als auch eine verbesserte Steuerung des Depositionsprozesses. Zur Optimierung des Prozeßgasmischungsverhältnisses wird das Prozeßgas gezielt an das Plasma herangeführt, bevorzugt in der Nähe der Targetoberfläche. Eine weitere Möglichkeit der Optimierung des Depositionsprozesses kann darin liegen, die Position des Substrates und/oder das Nachfahren der Substratposition zu beeinflussen in Abhängigkeit der emissionsspektroskopisch beobachteten Schwankung in der Linienintensität. Dabei ist das erfindungsgemäße Verfahren keineswegs nur auf die Beschichtung kleiner Substrate, sondern in vorteilhafter Weise gerade auch bei großflächiger Beschichtung von Vorteil. Weiterhin könnten geeignete Profilblenden gezielt in das Targetplasma eingebracht werden.

Zur Verbesserung der HTSL-Schichtherstellung mit Hilfe der Kathodenzerstäubung erlaubt das erfindungsgemäße Verfahren eine Prozeßstabilisierung durch Konstanthaltung des beobachteten Profils des Emissionssignals. Dies kann durch zusätzliches und/oder vermindertes Anbieten des Prozeßgases geschehen.

Im Falle der Herstellung dünner Filme aus oxydischen, hochtemperatursupraleitenden Materialien mit Hilfe reaktiver Kathodenzerstäubung unter Verwendung von einem Sauerstoff/Argon-Gasgemisch ist es möglich, im Sinne des erfindungsgemäßen Verfahrens die Emissionslinie von 845 nm des atomaren Sauerstoffs zu beobachten und über das erhaltene Signal nachzusteuern. Es kann jedoch auch eine andere Emissionslinie des Sauerstoffs gewählt werden. Darüber hinaus ist auch die Möglichkeit gegeben, eine oder mehrere Emissionslinien der Inertgaskomponente Argon im Gasgemisch zu wählen. Schließlich könnte auch eine Emissionslinie einer anderen im Targetplasma vorhandenen Komponente gewählt werden.

Die erfindungsgemäße Aufgabe wird weiterhin gelöst durch eine Vorrichtung gemäß Anspruch 10. Weitere zweckmäßige oder vorteilhafte Ausführungsformen der erfindungsgemäßen Vorrichtung finden sich in den Ansprüchen 11 bis 16. Als Inertgas im Gasgemisch des Prozeßgases eignet sich z.B. Argon oder Xenon. Als reaktives Gas kann z.B. Stickstoff, Sauerstoff, Fluor oder einer der anderen reaktiven Gase der Hauptgruppe VI oder VII des periodischen Systems vorgesehen sein.

In den nachfolgenden Abbildungen sind Ergebnisse, erzielt mit dem erfindungsgemäßen Verfahren und der erfindungsgemäßen Vorrichtung dargestellt.

Es zeigen:
- Figur 1: relative, integrale, über das gesamte Querschnittsprofil gemessene Intensität der Emissionslinie bei 845 nm des atomaren Sauerstoffs als Funktion der Zeit ohne Nachsteuerung des Profils dieser Emissionslinie mit Hilfe des Prozeßgasmischungsverhältnisses;
- Figur 2: relative, integral über das gesamte Querschnittsprofil gemessene Intensität der Emissionslinie bei 845 nm des atomaren Sauerstoffs als Funktion der Zeit mit Nachsteuerung des Profils dieser Emissionslinie mit Hilfe des Prozeßgasmischungsverhältnisses;
- Figur 3: ortsaufgelöstes Querschnittsprofil zu zwei verschiedenen Zeiten während der Kathodenzerstäubung ohne stabiliserende Nachsteuerung des Profils der gewählten Emissionslinie mit Hilfe des Prozeßgasmischungsverhältnisses;
- Figur 4: ortsaufgelöstes Querschnittsprofil zu zwei verschiedenen Zeiten während der Kathodenzerstäubung mit Nachsteuerung des Profils der gewählten Emissionslinie mit Hilfe des Prozeßgasmischungsverhältnisses;
- Figur 5: Darstellung des Bereichs des Plasmas zwischen Target und Substrat.

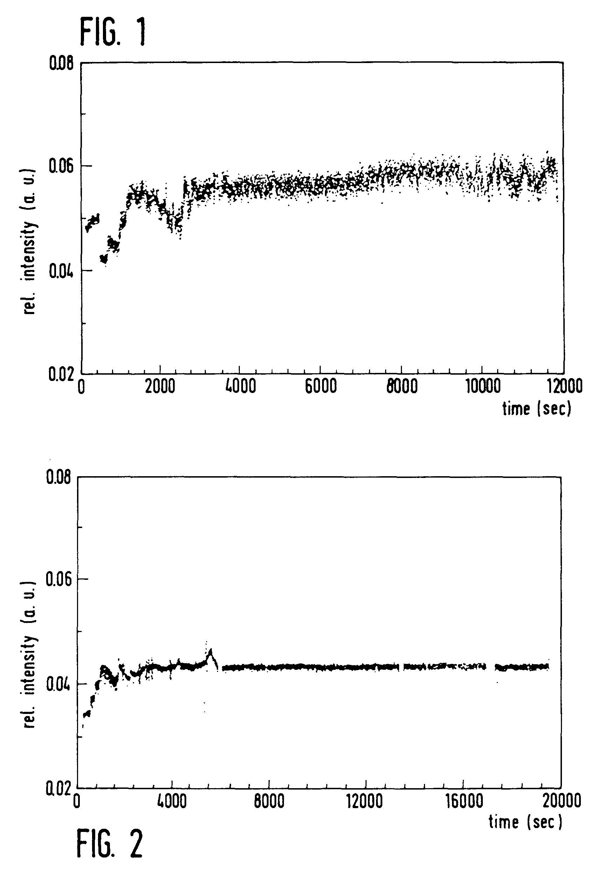

In den nachfolgenden Figuren 1 bis 5 werden Ergebnisse gezeigt zu der Herstellung eines Dünnfilmes aus hochtemperatursupraleitendem YBa₂Cu₃O₇ mit Hilfe der reaktiven Kathodenzerstäubung. Bei einem Prozeßgasdruck in der Prozeßkammer von 47 Pa (350 mTorr) wurde dabei ein Gasgemisch aus 40 Standard-ccm Argon und 20 Standard-ccm Sauerstoff gewählt.

In den Figuren 1 und 2 ist als Funktion der Zeit die relative Intensität der beobachteten Sauerstofflinie bei 845 nm, integral über das gesamte Querschnittsprofil gemessen, als Funktion der Zeit aufgetragen. Dabei beobachtet man in beiden Figuren den sog. Einsputtervorgang im Bereich der ersten 1000 - 2000 s.

Die Figur 1 zeigt Ergebnisse für den Fall, daß keine Nachsteuerung des Profils dieser Emissionslinie mit Hilfe des Prozeßgasmischungsverhältnisses stattgefunden hat. Es wurde deshalb ab etwa 3000 s eine Schwankung in der eingestellten Intensität oberhalb von 3000 s beobachtet. Zum einen sieht man Langzeitschwankungen z.B. im Zeitbereich von etwa 10000 - 12000 s, die im Bereich von Minuten liegen. Kurzzeitschwankungen im Bereich von Sekunden oder weniger sind die Ursache dafür, daß die Kurve z.B. im Bereich zwischen 4000 und 6000 s die dargestellte Breite zeigt. Eine Nachsteuerung des Profils der gewählten Emissionslinie mit Hilfe des Prozeßgasmischungsverhältnisses führte, wie in der Figur 2 dargestellt, im Ergebnis nach dem Einsputtervorgang zu einer erstaunlichen Verminderung der Schwankung in der relativen Intensität. In der Figur 2 zeigt sich z.B. oberhalb von 800 s eine drastische Reduzierung, sowohl der in der Figur beobachteten Langzeit - als auch der Kurzzeitschwankungen in der relativen Intensität. Im Ergebnis wurde eine weitaus bessere Dünnschichtherstellung mit der Nachsteuerung im Vergleich zu dem Fall ohne Nachsteuerung erzielt.

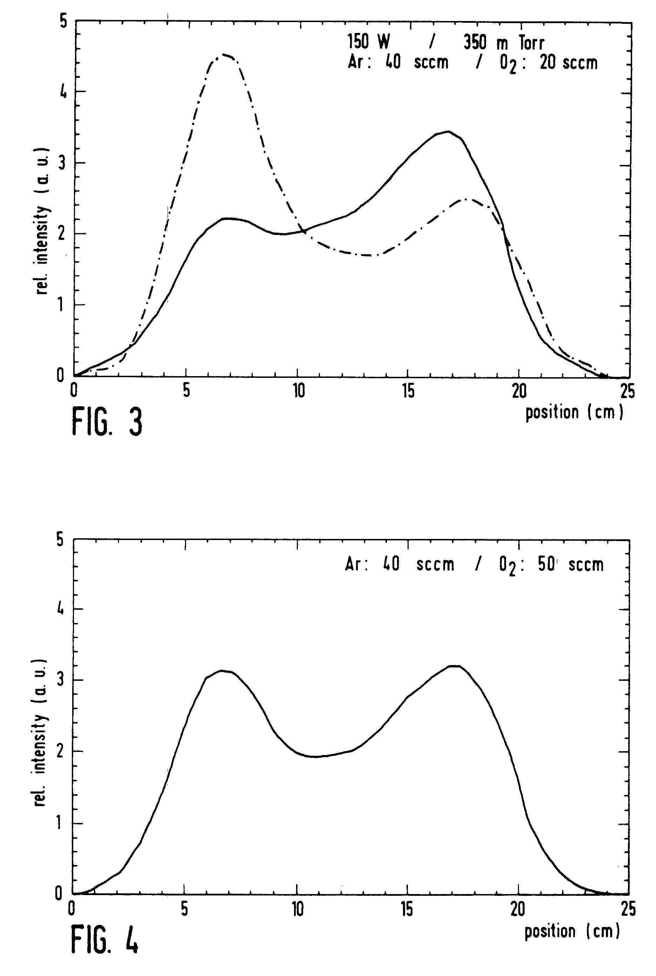

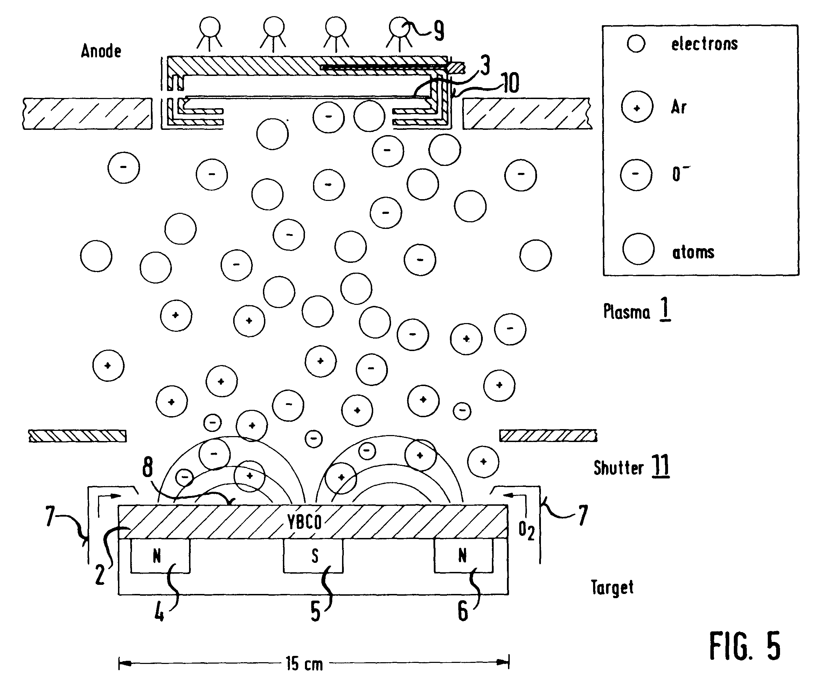

In den Figuren 3 und 4 sind die Ergebnisse zu den beiden oben geschilderten Experimenten in Bezug auf das ortsaufgelöste Querschnittsprofil angegeben.

Es zeigt sich unter den gleichen experimentellen Bedingungen wie oben angegeben, daß sich das gewünschte Querschnittsprofil während der Messung ändert. Es sind für zwei verschiedene Zeiten im Falle der fehlenden Nachsteuerung im obigen Sinne in der Figur 3 zwei Profile zu unterschiedlichen Zeiten dargestellt. Die drastischen Schwankungen in der Form des Profils verursachen eine zeitlich inhomogene Deposition des HTSL-Materials am Substrat. Durch Nachsteuerung im obigen Sinne konnte die Form des Querschnittsprofils konstant gehalten werden. Es stellte sich dann heraus, daß aufgrund dieser Maßnahme auch die kurzzeitigen Schwankungen im Plasma in vorteilhafter Weise stark reduziert wurden. Im Ergebnis lagen Dünnfilme mit verbesserten Eigenschaften vor.

In der Figur 5 ist schematisch der Bereich um das Plasma 1 zwischen dem Target 2 und dem Substrat 3 gezeigt. Als Targetmaterial ist hochtemperatursupraleitendes YBa₂Cu₃Oₓ gewählt. Desweiteren ist mit Hilfe eines Magnetsystems 4, 5, 6 ein Magnetfeld an der Targetoberfläche erzeugt worden (Magnetron). Mit Hilfe des Blendensystems 7 wird gezielt Sauerstoff (O₂) an die Targetoberfläche 8 herangeführt.

Während der Kathodenzerstäubung bildet sich im Bereich zwischen Target und Substrat aufgrund der Wahl des Prozeßgasgemisches Argon/Sauerstoff das Plasma 1 aus, das dabei die Komponenten der negativ geladenen Sauerstoffatome, sowie Elektronen, positiv geladene Argonatome sowie neutrale Teilchen (z.B. Y, Ba, Cu, Oxide, Ar) enthält.

Die negativ geladenen Teilchen, insbesondere die negativ geladenen Sauerstoffatome, werden in Richtung des als Anode 10 ausgebildeten Substrats beschleunigt. Das Substrat wurde durch Strahlungsheizungen 9 auf einer definierten, erhöhten Temperatur gehalten. Zur Einschnürung des Plasma 1 ist weiterhin ein Shutter 11 vorgesehen. Als Langmuirsonde diente in diesem Falle der Substrathalter 10.

Bei Substratdurchmesser von 4 Zoll und Targetdurchmesser von 6 Zoll bildete sich bei angelegter Spannung von ca. 200 Volt zwischen Kathode und Anode ein Strom von etwa 1 A aus. Es wurde dabei eine Spannung von ca. -16 Volt an dem als Langmuirsonde ausgebildeten Substrathalter beobachtet. Die Schwankungen im Plasma führten an der Sonde zu Änderungen des Spannungswertes von bis zu einigen Volt. Diese Schwankungen wurden durch Nachregelung des Prozeßgasgemisches beseitigt (kleiner 0,1 Volt).

Mit der nachgeregelten Vorrichtung wurden 100 - 300 nm dicke YBa₂Cu₃Oₓ-Schichten auf einem MgO-Substrat hergestellt. Alternativ könnte auch SrTiO₃ als Substratmaterial gewählt werden. Diese Schichten zeigten hinsichtlich der Homogenität des elektrischen Widerstandes, gemessen über die Substratoberfläche mit Schwankungen geringer als 2,5 % des mittleren Widerstandswertes, was einen extremen Wert für Hochtemperatursupraleiter bedeutet.

Im Vergleich dazu lag der Wert im Falle einer solchen Schichtherstellung ohne Nachregelung mit Hilfe der Langmuirsonde bei 25 % des mittleren Widerstandes.

## Patentansprüche

1. Verfahren zur Herstellung dünner Schichten mittels reaktiver Kathodenzerstäubung, bei dem in einer Prozeßkammer mit Gaseinlaß und Gasauslaß zwecks Steuerung eines als Gasgemisch vorhandenen Prozeßgases, wenigstens einem als Kathode vorgesehenen Target, sowie einem Substrat der Druck des Prozeßgases konstant gehalten wird, während Material vom Target abgestäubt und auf das Substrat abgeschieden wird,
**dadurch gekennzeichnet,**
**daß**
- das Prozeßgas in der Kammer bis an das das Target während der Kathodenzerstäubung umgebende Plasma herangeführt wird,
- wenigstens eine Sonde so angeordnet wird, daß geladene Atome des Prozeßgases detektiert werden,
- zur Erzielung der gewünschten Homogenität der Abscheidung des Targetmaterials auf das Substrat der Spannungswert an der Sonde durch eine Nachregelung des Prozeßgasmischungsverhältnisses konstant geregelt wird.

2. Verfahren nach Anspruch 1,
**dadurch gekennzeichnet,**
**daß** wenigstens eine Sonde in der Nähe des Plasma, insbesondere unmittelbar außerhalb der sichtbaren Plasmawolke angeordnet wird.

3. Verfahren nach Anspruch 1 oder 2,
**dadurch gekennzeichnet, daß** als Prozeßgas ein aus wenigstens einem Inertgas und wenigstens einem reaktiven Gas der Hauptgruppe VI oder VII, insbesondere O₂, N₂ oder F₂, zusammengesetztes Gasgemisch gewählt wird.

4. Verfahren nach einem der Ansprüche 1 bis 3,
**dadurch gekennzeichnet, daß** als Prozeßgas eine Mischung aus Argon und Sauerstoff gewählt wird.

5. Verfahren nach einem der Ansprüche 1 bis 4,
**dadurch gekennzeichnet, daß** der relative Gehalt des reaktiven Gases im Gasgemisch im Bereich von 5 bis zu 80 % gewählt wird.

6. Verfahren nach einem der Ansprüche 1 bis 5,
**dadurch gekennzeichnet, daß** als Material für das Target ein oxydischer Hochtemperatursupraleiter gewählt wird.

7. Verfahren nach einem der vorherigen Ansprüche,
**dadurch gekennzeichnet, daß** ein als Bias vorgesehenes, auf einem geeigneten elektrischen Potential gehaltenes Blendensystem im Bereich des während der Kathodenzerstäubung das Target umgebende Plasmas so angeordnet wird, daß mit einer damit verbundenen Einschnürung des Plasmas eine erhöhteStabilität des Spannungswertes an der Sonde erreicht wird.

8. Verfahren nach einem der vorherigen Ansprüche,
**dadurch gekennzeichnet,**
**daß** als Sonde eine Langmuirsonde oder ein Faradaykäfig oder eine Kombination dieser beiden vorgesehen wird.

9. Verfahren nach einem der vorhergehenden Ansprüche,
**dadurch gekennzeichnet,**
**daß** als Sonde das als Bias vorgesehene Blendensystem und/oder der Substrathalter und/oder der Targethalter gewählt wird.

10. Vorrichtung zur Herstellung dünner Schichten mit Hilfe einer zur reaktiven Kathodenzerstäubung geeigneten Kammer mit Gaseinlaß und Gasauslaß zwecks Steuerung eines als Gasgemisch vorhandenen Prozeßgases, wenigstens einem als Kathode vorgesehenen Target, sowie einem Substrat,
**dadurch gekennzeichnet,**
**daß**
- eine Prozeßgasführung vorgesehen ist, die das Gas in der Kammer vom Gaseinlaß bis an das das Target während der Kathodenzerstäubung umgebende Plasma heranführt,
- wenigstens eine Sonde als Detektor von geladenen Atomen des Prozeßgases vorgesehen ist, die in der Nähe des Plasmas angeordnet ist,
- ein Regelsystem vorgesehen ist, das in Abhängigkeit der erwünschten Homogenität der auf das Substrat abgeschiedenen Materialschicht durch Nachregelung des Prozeßgasmischungsverhältnisses den Spannungswert an der Sonde auf einen konstanten Wert hält.

11. Vorrichtung nach Anspruch 10,
**dadurch gekennzeichnet, daß** als Prozeßgas ein Gasgemisch aus wenigstens einem Inertgas und wenigstens einem reaktiven Gas der Hauptgruppe VI oder VII, insbesondere O₂, N₂ oder F₂, vorgesehen ist.

12. Vorrichtung nach Anspruch 10 oder 11,
**dadurch gekennzeichnet, daß** als Prozeßgas eine Mischung aus Argon und Sauerstoff vorgesehen ist.

13. Vorrichtung nach einem der Ansprüche 10 bis 12,
**dadurch gekennzeichnet, daß** als Targetmaterial ein oxydischer Hochtemperatursupraleiter vorgesehen ist.

14. Vorrichtung nach einem der Ansprüche 10 bis 13,
**dadurch gekennzeichnet, daß** als Bias ein auf einem geeigneten elektrischen Potential gehaltenes Blendensystem zur Einschnürung des Targetplasmas vorgesehen ist.

15. Vorrichtung nach einem der Ansprüche 10 bis 14,
**dadurch gekennzeichnet, daß** als Sonde eine Langmuirsonde oder ein Faradaykäfig vorgesehen ist.

16. Vorrichtung nach einem der Ansprüche 10 bis 15,
**dadurch gekennzeichnet, daß** als Sonde das Blendensystem und/oder der Substrathalter und/oder der Targethalter vorgesehen ist/sind.

## Claims

1. Process for the production of thin films by reactive cathodic sputtering, wherein in a process chamber ― with gas inlet and gas outlet for the purpose of controlling a process gas present as a gas mixture, at least one target provided as cathode, and a substrate ― the pressure of the process gas is kept constant as material is evaporated from the target and deposited on the substrate, **characterized in that**
- the process gas in the chamber is conveyed as far as the plasma surrounding the target during sputtering,
- at least one probe is disposed so that charged atoms of the process gas are detected,
- to obtain the desired homogeneity of deposition of target material on the substrate, the voltage level at the probe is kept constant by regulating the process gas mixing ratio.

2. Process according to Claim 1, **characterized in that** at least one probe is disposed near the plasma, in particular immediately outside the visible plasma cloud.

3. Process according to Claim 1 or Claim 2, **characterized in that** a gas mixture composed of at least one inert gas and at least one reactive gas of main group VI or VII, in particular O₂, N₂ or F₂, is selected as process gas.

4. Process according to any one of Claims 1 to 3, **characterized in that** a mixture of argon and oxygen is selected as process gas.

5. Process according to any one of Claims 1 to 4, **characterized in that** the relative content of the reactive gas in the gas mixture is selected in the range of 5 to 80 %.

6. Process according to any one of Claims 1 to 5, **characterized in that** an oxidic high-temperature superconductor is selected as material for the target.

7. Process according to any one of the preceding claims, **characterized in that** a screen system provided as bias and kept at a suitable electrical potential is disposed in the region of the plasma surrounding the target during sputtering so that by the resulting constriction of the plasma, increased stability of the voltage level at the probe is obtained.

8. Process according to any one of the preceding claims, **characterized in that** a Langmuir probe or a Faraday cage, or a combination of the two, is provided as probe.

9. Process according to any one of the preceding claims, **characterized in that** the screen system provided as bias and/or the substrate holder and/or the target holder is selected as probe.

10. Apparatus for the production of thin films by means of a suitable chamber for reactive cathodic sputtering, with gas inlet and gas outlet for the purpose of controlling a process gas present as a gas mixture, at least one target provided as cathode, and a substrate, **characterized in that**
- a means of guiding the process gas is provided which conveys the gas in the chamber from the gas inlet as far as the plasma surrounding the target during sputtering,
- at least one probe is provided, and disposed near the plasma, as detector of charged atoms of the process gas,
- a regulating system is provided which in keeping with the desired homogeneity of the material layer deposited on the substrate keeps the voltage at the probe at a constant level by regulating the process gas mixing ratio.

11. Apparatus according to Claim 10, **characterized in that** a gas mixture composed of at least one inert gas and at least one reactive gas of main group VI or VII, in particular O₂, N₂ or F₂, is provided as process gas.

12. Apparatus according to Claim 10 or Claim 11, **characterized in that** a mixture of argon and oxygen is provided as process gas.

13. Apparatus according to any one of Claims 10 to 12, **characterized in that** an oxidic high-temperature superconductor is provided as target material.

14. Apparatus according to any one of Claims 10 to 13, **characterized in that** a screen system kept at a suitable electrical potential to constrict the target plasma is provided as bias.

15. Apparatus according to any one of Claims 10 to 14, **characterized in that** a Langmuir probe or a Faraday cage is provided as probe.

16. Apparatus according to any one of Claims 10 to 15, **characterized in that** the screen system and/or the substrate holder and/or the target holder is/are provided as probe.

## Revendications

1. Procédé d'obtention de couches minces au moyen d'une pulvérisation cathodique réactive, dans lequel on maintient constante, dans une chambre de procédé ayant une entrée pour des gaz et une sortie pour des gaz en vue de maîtriser un gaz de procédé présent sous la forme d'un mélange gazeux, au moins une cible prévue comme cathode ainsi qu'un substrat, la pression du gaz de procédé, tandis qu'on pulvérise le matériau de la cible et qu'on le dépose sur le substrat,
**caractérisé en ce que**
- on apporte le gaz de procédé dans la chambre jusqu'au plasma entourant la cible pendant la pulvérisation cathodique,
- on dispose au moins une sonde, de manière à détecter des atomes chargés du gaz de procédé,
- pour obtenir l'homogénéité souhaitée du dépôt du matériau de cible sur le substrat, on règle à une valeur constante la valeur de la tension sur la sonde en réglant le rapport de mélange du gaz de procédé.

2. Procédé suivant la revendication 1, **caractérisé en ce que** l'on dispose au moins une sonde à proximité du plasma, notamment juste à l'extérieur du nuage de plasma visible.

3. Procédé suivant la revendication 1 ou 2, **caractérisé en ce que** l'on choisit comme gaz de procédé un mélange gazeux composé d'au moins un gaz inerte et d'au moins un gaz réactif des groupes principaux VI ou VII, notamment O₂, N₂ ou F₂.

4. Procédé suivant l'une des revendications 1 à 3, **caractérisé en ce que** l'on choisit comme gaz de procédé un mélange d'argon et d'oxygène.

5. Procédé suivant l'une des revendications 1 à 4, **caractérisé en ce que** la teneur relative du gaz réactif dans le mélange gazeux est de l'ordre de 5 à 80 %.

6. Procédé suivant l'une des revendications 1 à 5, **caractérisé en ce qu'**on choisit comme matériau pour la cible un supraconducteur à haute température oxydé.

7. Procédé suivant l'une des revendications précédentes, **caractérisé en ce que** l'on dispose un système d'écran prévu en tant que dispositif de polarisation et maintenu à un potentiel électrique approprié dans la partie du plasma entourant la cible pendant la pulvérisation cathodique, de façon à obtenir, par un rétrécissement du plasma qui s'ensuit, une plus grande stabilité de la valeur de la tension appliquée à la sonde.

8. Procédé suivant l'une des revendications précédentes, **caractérisé en ce que** l'on prévoit comme sonde une sonde de Langmuir ou une cage de Faraday ou une combinaison des deux.

9. Procédé suivant l'une des revendications précédentes, **caractérisé en ce que** l'on choisit comme sonde le système d'écran prévu comme dispositif de polarisation et/ou le porte-substrat et/ou le porte-cible.

10. Dispositif d'obtention de couche mince à l'aide d'une chambre appropriée à la pulvérisation cathodique réactive et ayant une entrée pour du gaz et une sortie pour du gaz en vue de se rendre maître du gaz de procédé présent sous la forme d'un mélange gazeux, au moins une cible prévue comme cathode, ainsi qu'un substrat, **caractérisé en ce que**
- il est prévu un dispositif de guidage du gaz de procédé qui envoie le gaz dans la chambre par l'entrée pour le gaz jusqu'au plasma entourant la cible pendant la pulvérisation cathodique,
- il est prévu au moins une sonde comme détecteur d'atomes chargés du gaz de procédé qui est disposée à proximité du plasma,
- il est prévu un système de réglage qui, en fonction de l'homogénéité souhaitée de la couche de matière déposée sur le substrat, maintient à une valeur constante la valeur de la tension appliquée à la sonde en réglant le rapport de mélange du gaz de procédé.

11. Dispositif suivant la revendication 10, **caractérisé en ce que** l'on choisit comme gaz de procédé un mélange gazeux composé d'au moins un gaz inerte et d'au moins un gaz réactif des groupes principaux VI ou VII, notamment O₂, N₂ ou F₂.

12. Dispositif suivant la revendication 10 ou 11, **caractérisé en ce que** l'on choisit comme gaz de procédé un mélange d'argon et d'oxygène.

13. Dispositif suivant l'une des revendications 10 à 12, **caractérisé en ce qu'**il est prévu comme matériau de cible un supraconducteur haute température oxydé.

14. Dispositif suivant l'une des revendications 10 à 13, **caractérisé en ce qu'**il est prévu comme dispositif polarisateur un système d'écran qui est maintenu à un potentiel électrique approprié et qui est destiné à rétrécir le plasma de cible.

15. Dispositif suivant l'une des revendications 10 à 14, **caractérisé en ce qu'**il est prévu comme sonde une sonde de Langmuir ou une cage de Faraday.

16. Dispositif suivant l'une des revendications 10 à 15, **caractérisé en ce qu'**il est prévu comme sonde le système d'écran et/ou le porte-substrat et/ou le porte-cible.
